# EUROPÄISCHE PATENTSCHRIFT

(11) **EP 1 418 670 B1**
(45) Veröffentlichungstag und Bekanntmachung des Hinweises auf die Patenterteilung: **04.08.2010**
(21) Anmeldenummer: 03024618.5
(22) Anmeldetag: 25.10.2003
(51) Int. Cl.: H03G 3/30

(54) **Leistungsregelung für Hochfrequenzverstärker**
Power control for a high frequency amplifier
Contrôle de puissance d'un amplificateur haute fréquence

(30) Priorität: 29.10.2002 DE 10250229
(43) Veröffentlichungstag der Anmeldung: 12.05.2004
(73) Patentinhaber: HÜTTINGER Elektronik GmbH + Co. KG, 79111 Freiburg (DE)
(72) Erfinder: Glück, Michael, 79106 Freiburg (DE)
(74) Vertreter: Kohler Schmid Möbus

(56) Entgegenhaltungen:
- GB-A- 2 260 871
- US-B1- 6 298 222

## Beschreibung

### Stand der Technik

Die Erfindung betrifft ein Verfahren zum Regeln der Eingangsspannung eines Hochfrequenzverstärkers und eine-Regelanordnung zur Durchführung des Verfahrens.

Die Regelung der Ausgangsspannung und damit der Leistung der meisten im Schaltbetrieb arbeitenden Hochfrequenzverstärkern (HF-Verstärker), z.B. Klasse E-Verstärkern, kann nur über die Regelung der Eingangsspannung des HF-Verstärkers erfolgen. Diese Eingangsspannung ist gleich der Ausgangsspannung einer Gleichstromversorgung. Somit ist die Gleichstromversorgung in die Regelung einbezogen. Gleichstromversorgungseinheiten, insbesondere solche, die im geschalteten Betrieb arbeiten, sind wegen eines vorgegebenen internen Taktes und vorhandener Filterelemente häufig zu langsam, um die Eingangsspannung eines HF-Verstärkers für Plasmaprozesse oder die Laseranregung zu regeln.

Aus der US 4,890,216 ist es bekannt, unmittelbar vor dem HF-Verstärker ein lineares Längsglied vorzusehen. Bereits in dieser Druckschrift wird erkannt, dass mit dieser Maßnahme ein großer Leistungsverlust und eine hohe Wärmeentwicklung verbunden ist. Wegen der hohen Leistungsverluste ist eine vollständige Spannungsregelung mit einem linearen Längsglied nicht möglich. Deshalb schlägt die US 4,890,216 vor, ein schnelles geschaltetes Längsglied zu verwenden. Ein solches schnelles geschaltetes Längsglied ist jedoch im Aufbau aufwändiger als eine herkömmliche Gleichstromversorgungseinheit. Außerdem weist ein geschaltetes Längsglied eine Spannungsquellencharakteristik und damit einen geringen Innenwiderstand auf. Dadurch können sich unerwünschte Resonanzen leicht anregen, die unzureichend bedämpft werden.

Aus der US 6,298,222 B1 ist ein HF-Verstärker bekannt, der an eine Leistungsversorgung angeschlossen ist. Die Ausgangsleistung des HF-Verstärkers wird geregelt. Dazu erfolgt zunächst eine Grobeinstellung eines DC/DC Wandlers in der Leistungsversorgung. Weiterhin wird ein verlustbehafteter Wandler, angedeutet durch einen einstellbaren Widerstand, verwendet. Die Feineinstellung der vorgegebenen Leistung wird durch den Wandler vorgenommen, der durch eine Stellgröße angesteuert wird, die aus einem Vergleich der aktuellen mit einer vorgegebenen Leistung ermittelt wird.

Aus der GB 2 260 871 A ist es bekannt, die Spannungsversorgung für einen HF-Verstärker mit einem Regelglied so einzustellen, dass bei steigendem Strombedarf des HF-Verstärkers die Spannung zurückgenommen wird.

### Aufgabe der Erfindung

Aufgabe der vorliegenden Erfindung ist es, ein Verfahren bereitzustellen, das einen zuverlässigen Betrieb eines HF-Verstärkers im Pulsbetrieb sicherstellt, sowie eine Regelanordnung zur Durchführung des Verfahrens bereitzustellen.

### Gegenstand der Erfindung

Erfindungsgemäß wird diese Aufgabe durch ein Verfahren mit den Merkmalen des Patentanspruchs 1 gelöst.

Unter Last im Sinne der Erfindung wird eine einfache Last, insbesondere ein Plasmaprozess oder eine Laseranregungsstrecke verstanden. Unter Last wird im Sinne der Erfindung aber auch eine Kombination aus einer oben genannten einfachen Last und einem vorgeschalteten Anpassungsnetzwerk und/oder einer Übertragungsleitung oder weiterer Bauteile verstanden.

Wenn im Folgenden von Leistungsmessung die Rede ist, wird darunter immer die Messung der Vorwärtsleistung, der reflektierten Leistung oder beider Leistungen verstanden. Die Kombination einer Regelung für das Längsglied und einer Regelung für die Gleichstromversorgungseinheit hat den Vorteil, dass durch das Längsglied eine schnelle Regelung bzw. Anpassung der in eine Last gelieferten Leistung erfolgen kann. Dabei ist die Ausgangsspannung des Längsglieds gleich der Eingangsspannung des HF-Verstärkers. Die am Ausgang des Leistungsverstärkers gemessene Leistung, also die in Richtung der Last gelieferte, die von der Last reflektierte Leistung oder Anteile von beiden, ist die zu regelnde Größe, also die Regelgröße. Die in die Last gelieferte und/oder von der Last reflektierte Leistung wird in der Regel indirekt über Richtkoppler gemessen. Es werden also die Vorwärtsleistung, die reflektierte Leistung oder beide Leistungen gemessen. Die von der Last reflektierte Leistung ist ein Maß für die Güte der Anpassung. Tritt eine große reflektierte Leistung auf, so muss die Ausgangsleistung so geregelt werden, dass der Leistungsverstärker vor Zerstörung geschützt wird und weniger Leistung reflektiert wird. Dadurch, dass über die Regelung der Gleichstromversorgungseinheit der Spannungsabfall über dem Längsglied in vorbestimmten Grenzen gehalten wird, kann die im Längsglied verbrauchte Leistung beeinflusst und im Vergleich zum Stand der Technik reduziert werden. Außerdem können größere Leistungsbereiche über einen größeren Zeitbereich über die Gleichstromversorgungseinheit geregelt werden. Ein weiterer Vorteil des Verfahrens liegt darin, dass die HF Belastung der Gleichstromversorgungseinheit unterdrückt wird. Durch Pulsen, z.B. bei Laseranwendungen, oder durch Instabilitäten, z.B. bei Plasmaanwendungen werden in der Gleichstromversorgungseinheit Schwingungen angeregt. Diese wiederum regen L-C-Filterglieder (Serieninduktivität L und Parallelkapazität C) an den Ausgängen der Gleichstromversorgungseinheit zu Schwingungen aufgrund ihrer Eigenresonanz an. Die HF Belastung der Gleichstromversorgungseinheit wird dadurch reduziert, dass das Längsglied dämpfend auf die Schwingungsanregung der L-C-Filterglieder der Gleichstromversorgungseinheit wirkt.

Bei einer bevorzugten Variante des Verfahrens ist die Regeldauer für die Regelung des Längsglieds kürzer als die für die Gleichstromversorgungseinheit. Insbesondere beträgt die Regeldauer für die Regelung des Längsglieds bevorzugt weniger als 10 ms, typischerweise zwischen 10 µs und 1 ms. Durch diese Maßnahme kann eine langsame Regelung der Verlustleistung des Längsglieds über die Gleichstromversorgungseinheit und eine schnelle Leistungsregelung des HF-Verstärkers über das Längsglied erfolgen. Die Regeldauer für die Gleichstromversorgungseinheit für sich ist zu lang, um den HF-Verstärker z.B. zur Laseranregung zu verwenden. Die zwischengeschaltete schnelle Leistungsregelung des Längsglieds ermöglicht eine Verwendung des HF-Verstärkers u.a. zur Laseranregung bei gleichzeitiger Minimierung der Verlustleistung in der Ansteuerung des HF-Verstärkers. Somit wird die erforderliche Dynamik der Eingangsspannung des HF-Verstärkers erreicht.

Bei einer weiteren Verfahrensvariante wird aus der an einem Schalterelement des HF-Verstärkers anliegenden Spannung U_{DS} und einem Sollwert für die maximale Spannung U_{DS} eine dritte Stellgröße und/oder aus der am Ausgang des Hochfrequenzverstärkers gemessenen Leistung und einem vorgegebenen Sollwert für die Leistung eine vierte Stellgröße für das Längsglied ermittelt. Durch diese Maßnahme wird der HF-Verstärker geschützt. Wenn der aktuelle Wert der Spannung U_{DS} oder die im HF-Verstärker erzeugte Leistung von vorgegebenen internen Sollwerten abweichen, wird über die dritte oder vierte Stellgröße so in das Längsglied eingegriffen, dass die aktuellen Werte für U_{DS} und die erzeugte Leistung in einem zulässigen Bereich liegen. Dieser Bereich ist so gewählt, dass der HF-Verstärker und nachfolgende Bauelemente bzw. Baugruppen nicht zerstört werden.

Bei einer Verfahrensvariante wird aus einem am Ausgang des Längsglieds gemessenen Strom und einem vorgegebenen internen Sollwert für den maximalen Strom eine fünfte Stellgröße ermittelt. Wenn der aktuelle Wert des Stroms über den vorgegebenen Maximalwert steigt, wird das Längsglied so gesteuert, dass der Strom in den zulässigen Bereich kommt. Durch diese Maßnahme wird das Längsglied geschützt und der Leistungsverbrauch im Längsglied eingestellt.

Besonders vorteilhaft ist es, wenn dem Längsglied nur die Stellgröße (erste oder dritte oder vierte oder fünfte Stellgröße) zugeleitet wird, die die stärkste Regelung vornimmt. Auf diese Weise wird das Längsglied durch diejenige Stellgröße beeinflusst, die die vorrangige Regelung vornimmt.

Wenn die Regeldauer für die erste, dritte, vierte oder fünfte Stellgröße << 10 ms ist, kann das Längsglied so schnell beeinflusst werden, dass Spannungsschwankungen (Ripple) am Anodenpotential einer dem HF-Verstärker nachgeschalteten Röhrenendstufe ausgeglichen werden können, wobei die Spannungsschwankungen durch die endliche Glättung der gleichgerichteten Hochspannung am Anodenpotential verursacht sein können. Hier ist zu beachten, dass die Last des HF-Verstärkers der Eingang der nachgeschalteten Röhrenendstufe ist. Am Ausgang der Röhrenendstufe ist wiederum eine oben genannte einfache Last oder eine vorbeschriebene Kombination von Lasten angeschlossen. Die erste Stellgröße wird dabei aus der am Ausgang der Röhrenendstufe gemessenen Leistung ermittelt.

Bei einer besonders bevorzugten Verfahrensvariante werden das Längsglied und ein mit dem Hochfrequenzverstärker in Verbindung stehender Oszillator synchron ein- und ausgeschaltet. Diese Maßnahme ermöglicht eine Unterbrechung der Gleichstromversorgung und dadurch einen gepulsten Betrieb eines als Last betriebenen Lasers oder Plasmas und kontrollierte Startbedingungen für den HF-Verstärker. Das Ein- und Ausschalten der Gleichstromversorgungseinheit wäre für einen gepulsten Betrieb zu langsam. Dem könnte durch An- und Ausschalten des mit dem HF-Verstärker verbundenen Oszillators begegnet werden. Die Gleichstromversorgungseinheit würde aber durchgehend Strom liefern und die Kondensatoren im HF-Verstärker aufladen, woraus sich veränderte Startbedingungen ergeben. Das synchrone und schnelle Ein- und Ausschalten des Längsglieds und des Oszillators ermöglicht dagegen eine hohe Pulsfrequenz und kontrollierte Startbedingungen für den HF-Verstärker.

Bei einer Weiterbildung wird mindestens eine Regelstufe synchron mit dem Längsglied an- und ausgeschaltet. Vorzugsweise werden die erste Regelstufe zur Ermittlung der ersten Stellgröße, eine dritte Regelstufe zur Ermittlung der dritten Stellgröße, eine vierte Regelstufe zur Ermittlung der vierten Stellgröße und eine fünfte Regelstufe zur Ermittlung der fünften Stellgröße synchron mit dem Längsglied an- und ausgeschaltet. Somit wird vermieden, dass während das Längsglied ausgeschaltet ist, was eine geringe Leistungsabgabe des HF-Verstärkers zur Folge hat, eine Nachregelung erfolgt. Es ist auch denkbar, weitere Regelstufen vorzusehen, die auch synchron mit dem Längsglied an- und ausgeschaltet werden.

Die Aufgabe wird erfindungsgemäß außerdem durch eine Regelanordnung mit den Merkmalen des Anspruchs 10 gelöst.

Die Verwendung der Kombination einer Gleichstromversorgungseinheit und eines Längsglieds hat den Vorteil, dass zum einen über das Längsglied die in eine Last gelieferte bzw. von dieser reflektierten Leistung schnell geregelt werden kann und dass zum anderen durch die vergleichsweise langsame Regelung der Gleichstromversorgungseinheit der Spannungsabfall über dem Längsglied kontrolliert und innerhalb vorgegebener Werte gehalten werden kann. Dadurch kann die Eingangsspannung des HF-Verstärkers, insbesondere eines Klasse E Verstärkers, zur Erreichung einer gewünschten Ausgangsspannung des HF-Verstärkers schnell angepasst werden und die Verlustleistung im Längsglied reduziert werden. Unter schneller Regelung versteht man, dass der die erste Regelstufe umfassende Regelkreis zur Regelung weniger als 10 ms benötigt. Das Längsglied weist eine Stromquellencharakteristik auf und unterbindet daher Resonanzen in der Gleichspannungszuführung des HF-Verstärkers. Die Verwendung eines Längsglieds, mit dem die Eingangsspannung des HF-Verstärkers schnell geregelt werden kann, ermöglicht es, die Spannungsschwankungen der gleichgerichteten Spannung am Anodenpotential einer dem HF-Verstärker nachgeschalteten Röhrenendstufe auszugleichen. Dies geschieht, indem aus der Ausgangsleistung der Röhrenendstufe, welche der in eine Last gelieferten Leistung entspricht, und dem Sollwert für die in eine Last gelieferten Leistung in der ersten Regelstufe eine erste Stellgröße für das Längsglied ermittelt wird.

Bei einer besonders bevorzugten Ausführungsform weist das Längsglied mindestens ein Halbleiterelement, insbesondere einen Transistor auf. Dadurch kann das Längsglied einfach und kostengünstig realisiert werden.

Vorteilhaft ist es, wenn eine dritte Regelstufe zum Ermitteln einer dritten Stellgröße vorgesehen ist, der die an einem Schalterelement des HF-Verstärkers anliegende Spannung U_{DS} zugeführt ist und die mit dem Längsglied in Verbindung steht. Es kann auch eine vierte Regelstufe zum Ermitteln einer vierten Stellgröße vorgesehen sein, der die am Ausgang des HF-Verstärkers gemessene Leistung zugeführt ist und die mit dem Längsglied in Verbindung steht. Die dritte und vierte Regelstufe stellen eine Schutzeinrichtung für den HF-Verstärker dar, in der überwacht wird, dass die Ausgangsleistung des HF-Verstärkers und die am Schalterelement anliegende Spannung keine unzulässigen Werte annehmen, insbesondere solche Werte, die den HF-Verstärker oder nachfolgende Bauelemente zerstören könnten. Als Schalterelement im HF-Verstärker kann vorteilhafterweise ein Feldeffekttransistor vorgesehen sein.

Bei einer bevorzugten Ausführungsform ist eine fünfte Regelstufe zum Ermitteln einer fünften Stellgröße aus dem am Ausgang des Längsglieds gemessenen Strom und einem vorgegebenen maximalen Sollwert für den Strom vorgesehen, die mit dem.Längsglied in Verbindung steht. Durch diese Maßnahme kann der Strom innerhalb eines definierten zulässigen Bereichs gehalten werden.

Wenn eine Auswahleinrichtung zur Auswahl der an das Längsglied zu übermittelnden Stellgröße vorgesehen ist, wird dem Längsglied diejenige Stellgröße (erste, dritte, vierte oder fünfte Stellgröße) zur Regelung zugeführt, die die größere Regelung vornimmt. Dies ist so zu verstehen, dass in den Regelstufen als Stellgrößen Spannungen erzeugt werden, die zu positiven Spannungen verstärkt werden. Die größte sich ergebende Spannung wird dann für die Regelung des Längsglieds verwendet.Die Auswahlvorrichtung, die die größte Spannung auswählt, besteht vorzugsweise aus Dioden, deren Anzahl der mit der Auswahleinrichtung in Verbindung stehenden Regelstufen entspricht. Es ist auch denkbar, mehr als die oben genannten Regelstufen vorzusehen, die Stellgrößen ermitteln und der Auswahleinrichtung zuführen. Vorzugsweise werden die erste, dritte, vierte und fünfte Stellgröße in den entsprechenden Regelstufen so schnell ermittelt, dass das Längsglied mit einer Regeldauer von << 10 ms geregelt werden kann.

Bei einer vorteilhaften Ausführungsform ist ein Befehlsgeber, insbesondere ein Pulsgenerator, vorgesehen, der mit einem Oszillator zur Ansteuerung des HF-Verstärkers und dem Längsglied oder einem mit dem Längsglied verbundenen Schalterelement verbunden ist. Diese Maßnahme ermöglicht den Einsatz der erfindungsgemäßen Regelanordnung zum Betrieb eines gepulsten Lasers oder Plasmaprozesses. Dadurch wird beispielsweise ein schnelles Zünden des Lasers ermöglicht. Dies ist nötig, um die vom Laser reflektierte Leistung möglichst gering zu halten. Beim Zünden des Lasers muss der HF-Verstärker zunächst einschwingen. Er benötigt eine gewisse Zeit, bis an seinem Ausgang eine ausreichend hohe Spannung anliegt, um den Laser zu zünden. Bis zu diesem Zeitpunkt ist der Lastwiderstand am HF-Verstärker, also die Laseranregungsstrecke, sehr hochohmig. Dadurch ist der HF-Verstärker stark fehlangepasst. Bei Fehlanpassung wird ein Teil der in die Last gelieferten Energie in den HF-Verstärker zurück reflektiert. Je größer die Fehlanpassung ist, desto mehr Energie wird zurück reflektiert. Die reflektierte Energie wird im Verstärker in Wärme umgewandelt, wodurch die Verstärkerbauteile belastet werden und der Wirkungsgrad sinkt. Um eine Überlastung zu verhindern und einen hohen Wirkungsgrad zu erreichen, ist es daher vorteilhaft, die reflektierte Leistung gering zu halten. Dies kann durch schnelles Zünden des Lasers erreicht werden.

Die Ausschaltung des Längsglieds kann dadurch erfolgen, dass der dem Längsglied als Stellgröße zugeführte Strom an- und ausgeschaltet wird. Da der Strom aber typischerweise von einem Verstärkerglied eingestellt wird, müsste das Verstärkerglied schnell zwischen zwei Stufen springen. Dies kann zu Instabilitäten und der Anregung hochfrequenter Schwingungen führen. Das kann dadurch vermieden werden, dass ein Schalterelement, insbesondere ein elektronischer Schalter eingesetzt wird, der das Längsglied an- und ausschalten. Ist als Längsglied ein Bipolartransistor vorgesehen, so geschieht dies vorteilhafterweise dadurch, dass das Schalterelement zwischen Basis und Emitter des Bipolartransistors angeordnet wird.

Wenn der Befehlsgeber mit mindestens einer, insbesondere der ersten, dritten, vierten und fünften Regelstufe verbunden ist, dann werden diese Regelstufen synchron mit dem Längsglied an- und ausgeschaltet. Bei geringer vom HF-Verstärker abgegebenen Leistung aufgrund des abgeschalteten Längsglieds erfolgt also keine Regelung durch die erste, dritte, vierte oder fünfte Regelstufe.

Weitere Merkmale und Vorteile der Erfindung ergeben sich aus der nachfolgenden Beschreibung von Ausführungsbeispielen der Erfindung, anhand den Figuren der Zeichnung, die erfindungswesentliche Einzelheiten zeigen, und aus den Ansprüchen.

### Zeichnung

Ausführungsbeispiele der erfindungsgemäßen Regelanordnung eines Hochfrequenzverstärkers sind in der schematischen Zeichnung dargestellt und werden in der nachfolgenden Beschreibung erläutert. Es zeigt:
- **Fig. 1**: eine schematische Darstellung einer Regelanordnung eines Hochfrequenzverstärkers mit zwei Regelstufen zur Erläuterung des technischen Umfelds der Erfindung;
- **Fig. 2**: eine schematische Darstellung einer Regelanordnung eines Hochfrequenzverstärkers mit mehr als zwei Regelstufen zur Erläuterung des technischen Umfelds der Erfindung;
- **Fig. 3**: eine schematische Darstellung einer erfindungsgemäßen Regelanordnung eines Hochfrequenzverstärkers mit einem Befehlsgeber;
- **Fig. 4**: eine schematische Darstellung einer erfindungsgemäßen Weiterbildung der Regelanordnung der Fig. 3.

### Beschreibung der Ausführungsbeispiele

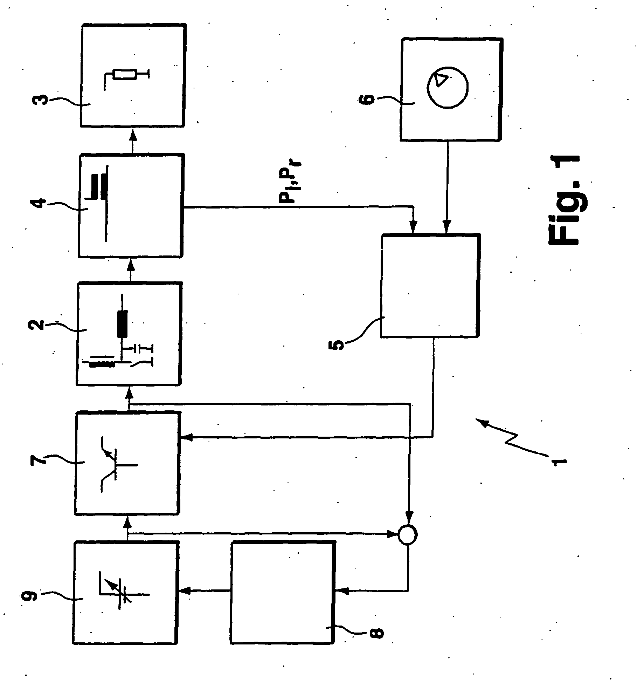

**Fig. 1** zeigt eine schematische Darstellung des Aufbaus einer erfindungsgemäßen Regelanordnung **1** eines Hochfrequenzverstärkers (HF-Verstärker) **2**. Die in eine Last **3** gelieferte (Vorwärtsleistung) und/oder von der Last 3 reflektierte Leistung (Rückwärtsleistung) wird in einer als Richtkoppler ausgebildeten ersten Messvorrichtung **4** gemessen und an eine erste Regelstufe **5** geleitet. Dies bedeutet, dass die Leistung am Ausgang der Regelanordnung 1 vor der Last 3 gemessen wird. Die gemessene Leistung umfasst dabei die in die Last gelieferte oder die reflektierte Leistung oder Anteile von gelieferter und reflektierter Leistung. Der ersten Regelstufe 5 wird die gewünschte in die Last 3 gelieferte (Nutz-)Leistung als Sollwert **6** extern vorgegeben. Aus der am Ausgang der Regelanordnung 1 bzw. am Ausgang des gesamten Leistungsverstärkers gemessenen Leistung und dem Sollwert 6 wird in der ersten Regelstufe 5 eine erste Stellgröße ermittelt, die einem Längsglied **7** zugeführt wird. Durch die erste Stellgröße wird über das Längsglied 7 die Eingangsspannung der HF-Verstärkers eingestellt. Der Spannungsabfall über dem Längsglied 7 wird einer zweiten Regelstufe **8** zugeführt, die mittels einer zweiten Stellgröße die als Spannungsquelle ausgebildete geschaltete Gleichstromversorgungseinheit **9** so einstellt, dass der Spannungsabfall am Längsglied 7 einen vorgegebenen Maximalwert nicht über- und einen vorgegebenen Minimalwert nicht unterschreitet. Durch die Begrenzung des Spannungsabfalls über dem Längsglied 7 wird die Verlustleistung im Längsglied 7 reduziert. Die Gleichstromversorgungseinheit 9 und das Längsglied 7 bilden zusammen die Gleichstromversorgung des HF-Verstärkers 2. Die erste Regelstufe 5 und das Längsglied 7 arbeiten so schnell, dass die Regeldauer unter 10 ms, typischerweise zwischen 10 µs und **1** ms liegt. Die Regelstufe 8 arbeitet langsamer, so dass die Verlustleistung des Längsglieds 7 und größere Leistungsänderungen über einen längeren Zeitraum eingestellt werden.

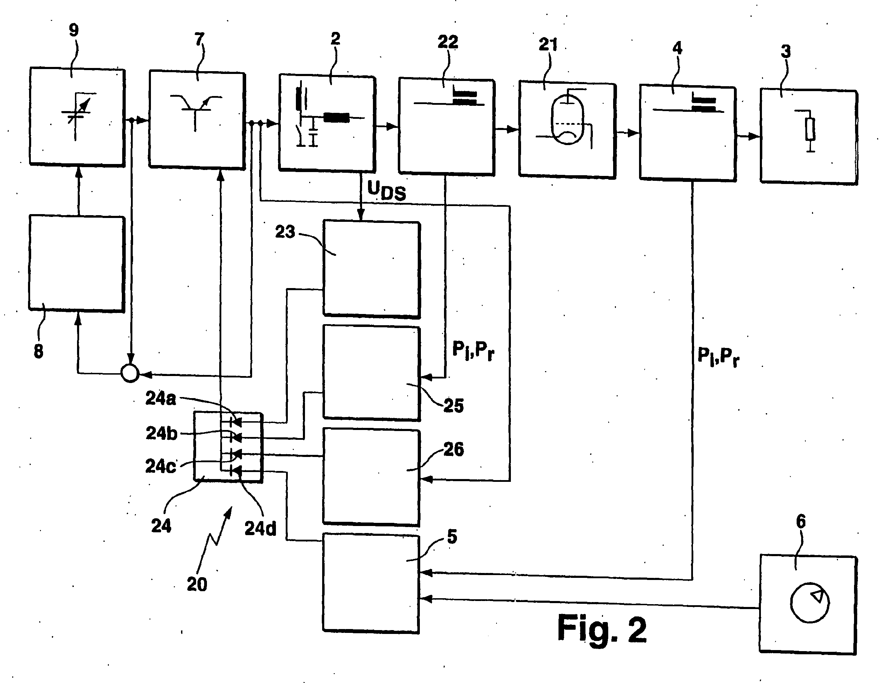

**Fig. 2** zeigt eine schematische Darstellung des Aufbaus einer alternativen Regelanordnung **20** eines HF-Verstärkers 2. In Fig. 2 sind der Fig. 1 entsprechende Blöcke mit gleichen Bezugsziffern bezeichnet. Dem HF-Verstärker 2 ist eine als Röhrenendstufe ausgebildete Endstufe **21** nachgeschaltet. Die von der Endstufe 21 in die Last 3 gelieferte Leistung, bzw. die am Ausgang der Regelanordnung 20 vor der Last **3** in der ersten Messeinrichtung 4 gemessene Leistung wird der ersten Regelstufe 5 zugeführt, wo aus der gelieferten Leistung und dem vorgegebenen Sollwert 6 eine Stellgröße für das Längsglied 7 ermittelt wird. Die Regelstufe 5 arbeitet in diesem Ausführungsbeispiel besonders schnell, z.B. << 10 ms. Dadurch wird die Eingangsspannung am HF-Verstärker 2 sehr schnell geregelt. Wegen der schnellen Regelung und der Verwendung der Ausgangsleistung der als Röhrenendstufe ausgebildeten Endstufe 21 als Regelgröße können Spannungsschwankungen (Ripple) an der Anode der Röhre ausgeglichen werden.

Die an einem im Ausführungsbeispiel als Feldeffekttransistor ausgebildeten Schalterelement des HF-Verstärkers 2 anliegende Spannung U_{DS} wird einer dritten Regelstufe **23** zugeführt. In der dritten Regelstufe 23 wird aus der zugeführten Spannung U_{DS} und einem intern vorgegebenen Sollwert eine dritte Stellgröße für das Längsglied 7 ermittelt. Die erste Stellgröße der ersten Regelstufe 5 und die dritte Stellgröße der dritten Regelstufe 23 werden zunächst einer Auswahleinheit **24** zugeführt. Die Vorwärts- und Rückwärtsleistung Pᵢ, Pᵣ werden in einer als Richtkoppler ausgebildeten zweiten Messvorrichtung **22** ermittelt und als Messwert einer vierten Regelstufe **25** zugeführt. Aus den Messwerten und einem intern vorgegebenen Wert wird eine vierte Stellgröße ermittelt, die an die Auswahleinheit 24 weitergegeben wird. Der Auswahleinheit **24** wird außerdem eine fünfte Stellgröße einer fünften Regelstufe **26** zugeführt, in der der aktuelle Stromwert am Ausgang des Längsglieds 7 mit einem vorgegebenen internen Maximalwert für den Strom verglichen wird. Die Auswahleinheit 24 wählt aus, welche Stellgröße an das Längsglied 7 weitergeleitet wird. Die Auswahl erfolgt im Ausführungsbeispiel über vier Dioden 24a - **24d**. Die Regeldauer der ersten, dritten, vierten und fünften Regelstufe 5, 23, 25, 26 liegt deutlich unter 10 ms.

Die zweite Regelstufe 8 und die Gleichstromversorgungseinheit 9 erfüllen dieselben Aufgaben wie in Fig. 1.

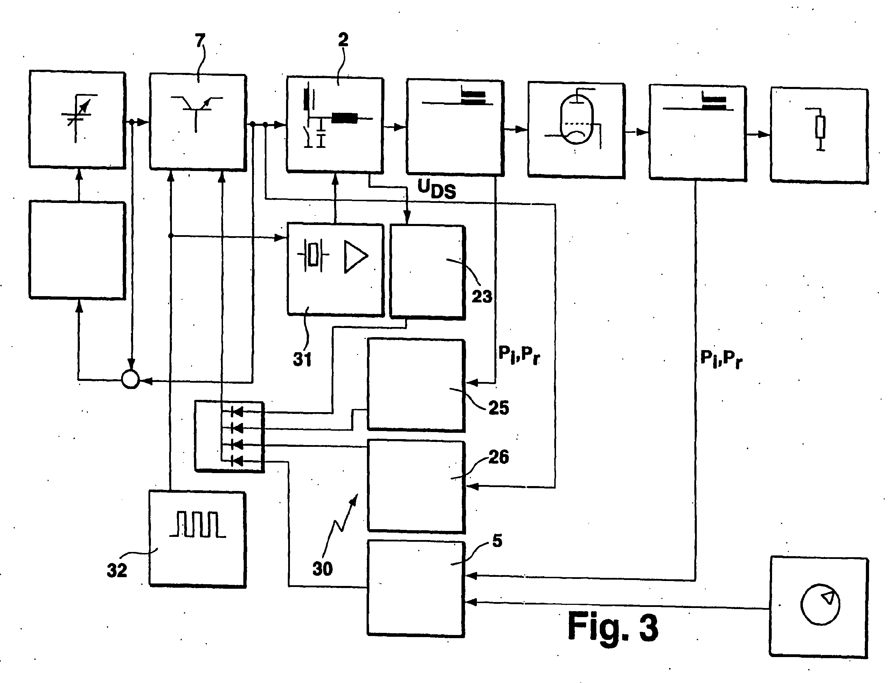

Die erfindungsgemäße Regelanordnung **30** in **Fig. 3** entspricht im Wesentlichen der der Fig. 2. Als zusätzliche Elemente weist sie einen Oszillator **31** mit Treiber für den HF-Verstärker 2 und einen als Pulsgenerator ausgebildeten Befehlsgeber **32** auf. Der Befehlsgeber 32 schaltet das Längsglied 7 und den Oszillator schnell und synchron ein und aus, so dass die Regelanordnung für den Betrieb von gepulsten Lasern mit einer Pulsfrequenz von etwa 100kHz eingesetzt werden kann.

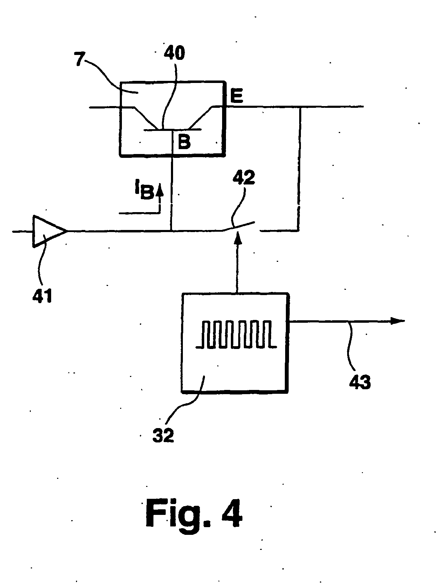

**Fig. 4** zeigt eine erfindungsgemäße Weiterbildung der Regelanordnung 30 der Fig. 3. Das Längsglied 7 ist durch einen als npn-Transistor ausgeführten Bipolartransistor **40** realisiert. Die Stellgrößen aus den Regelstufen 5, 23, 25, 26 der Fig. 3 werden dem Bipolartransistor 40 in Form eines Stromes I_{B} zugeführt. Dieser Strom I_{B} wird von einem Verstärkerglied **41** eingestellt. Das Pulsen des Längsglieds 7 erfolgt nicht über den Strom I_{B} , d.h. das Ein- und Ausschalten des Stromes I_{B}, sondern über das Schalterelement **42**. Die Basis B des Bipolartransistors 40 wird für die Dauer der Austastung mit Hilfe des Schalterelements 42, insbesondere einem elektronischen Schalter, welcher mit dem Befehlsgeber 32 verbunden ist, mit dem Emitter E des Bipolartransistors 40 kurzgeschlossen. Der Befehlsgeber 32 ist außerdem mit den Regelstufen 5, 23, 25, 26 und dem Oszillator 31 verbunden, was durch den Pfeil **43** angedeutet ist. Somit werden während der Ausschaltung des Längsglieds 7 auch die Regelstufen 5, 23, 25, 26 synchron ausgeschaltet.

Bei einem Verfahren zum Regeln der Eingangsspannung eines Hochfrequenzverstärkers 2 wird die in eine Last 3 gelieferte und/oder die von der Last 3 reflektierte Leistung gemessen. Es wird eine erste Stellgröße für ein dem Hochfrequenzverstärker 2 vorgeschaltetes Längsglied 7 aus der gemessenen Leistung und einem vorgegebenen Sollwert 6 und eine zweiten Stellgröße für eine geschaltete Gleichstromversorgungseinheit 9 aus dem Spannungsabfall über dem Längsglied 7 ermittelt, derart, dass der Spannungsabfall über dem Längsglied 7 einen vorgegebenen Maximalwert nicht überschreitet und einen vorgegebenen Minimalwert nicht unterschreitet. Dadurch kann eine schnelle Regelung der Eingangsspannung des HF-Verstärkers 2 bei gleichzeitiger Minimierung der Verlustleistung im Längsglied 7 erfolgen.

## Patentansprüche

1. Verfahren zum Regeln der Eingangsspannung eines Hochfrequenzverstärkers (2) mit den folgenden Verfahrensschritten:
a) Messen der in eine Last (3) gelieferten und/oder von der Last (3) reflektierten Leistung;
b) Ermitteln einer ersten Stellgröße für ein dem Hochfrequenzverstärker (2) vorgeschaltetes Längsglied (7) aus der gemessenen Leistung und einem vorgegebenen Sollwert (6);
**gekennzeichnet durch**
c) Ermitteln einer zweiten Stellgröße für eine geschaltete Gleichstromversorgungseinheit (9) aus dem Spannungsabfall über dem Längsglied (7), derart, dass der Spannungsabfall über dem Längsglied (7) einen vorgegebenen Maximalwert nicht überschreitet und einen vorgegebenen Minimalwert nicht unterschreitet, wobei das Längsglied (7), um den Hochfrequenzverstärker (2) in einem Pulsbetrieb zu betreiben, an- und ausgeschaltet wird.

2. Verfahren nach Anspruch 1, **dadurch gekennzeichnet, dass** das Längsglied (7) schneller geregelt wird als die Gleichstromversorgungseinheit (9).

3. Verfahren nach Anspruch 1 oder 2, **dadurch gekennzeichnet, dass** aus der an einem Schalterelement des Hochfrequenzverstärkers (2) anliegenden Spannung U_{DS} und einem Sollwert für die maximale Spannung U_{DS} eine dritte Stellgröße für das Längsglied (7) ermittelt wird.

4. Verfahren nach einem der vorhergehenden Ansprüche, **dadurch gekennzeichnet, dass** aus der am Ausgang des Hochfrequenzverstärkers (2) gemessenen Leistung und einem vorgegebenen Sollwert für die Leistung eine vierte Stellgröße für das Längsglied (7) ermittelt wird.

5. Verfahren nach einem der vorhergehenden Ansprüche, **dadurch gekennzeichnet, dass** aus einem am Ausgang des Längsglieds (7) gemessenen Strom und einem vorgegebenen internen Sollwert für den maximalen Strom eine fünfte Stellgröße ermittelt wird.

6. Verfahren nach einem der Ansprüche 3 bis 5, **dadurch gekennzeichnet, dass** dem Längsglied (7) nur die größte Stellgröße zugeleitet wird.

7. Verfahren nach einem der vorhergehenden Ansprüche, **dadurch gekennzeichnet, dass** die Regeldauer für die erste, dritte, vierte oder fünfte Stellgröße << 10 ms ist.

8. Verfahren nach einem der vorhergehenden Ansprüche, **dadurch gekennzeichnet, dass** das Längsglied (7) und ein mit dem Hochfrequenzverstärker (2) in Verbindung stehender Oszillator (31) synchron ein- und ausgeschaltet werden.

9. Verfahren nach Anspruch 8, **dadurch gekennzeichnet, dass** mindestens eine Regelstufe (5, 23, 25, 26) ebenfalls synchron mit dem Längsglied (7) an- und ausgeschaltet wird.

10. Regelanordnung (1, 20, 30) eines Hochfrequenzverstärkers (2) zur Durchführung des Verfahrens nach einem der vorhergehenden Ansprüche mit einem dem Hochfrequenzverstärker (2) vorgeschalteten Längsglied (7), dem eine erste Regelstufe (5) zum Ermitteln einer ersten Stellgröße aus der in eine Last (3) gelieferten und/oder von der Last (3) reflektierten Leistung und einem Sollwert (6) zugeordnet ist, **dadurch gekennzeichnet, dass** eine geschaltete Gleichstromversorgungseinheit (9) mit einer ihr zugeordneten aus dem Spannungsabfall über dem Längsglied (7) eine zweite Stellgröße ermittelnden zweiten Regelstufe (8) vorgesehen ist, derart, dass der Spannungsabfall über den Längsglied einen vorgegebenen Maximalwert nicht überschreitet und einen vorgegebenen Minimalwert nicht unterschreitet wobei das Längsglied als ein- und ausschaltbares Längsglied (7) ausgebildet ist um den Hochfrequenzverstärker in einem Pulsbetrieb zu betreiben.

11. Regelanordnung nach Anspruch 10, **dadurch gekennzeichnet, dass** das Längsglied (7) mindestens ein Halbleiterelement, insbesondere einen Transistor aufweist.

12. Regelanordnung nach Anspruch 10 oder 11, **dadurch gekennzeichnet, dass** eine dritte Regelstufe (23) zum Ermitteln einer dritten Stellgröße vorgesehen ist, der die an einem Schalterelement des HF-Verstärkers anliegende Spannung U_{DS} zugeführt ist und die mit dem Längsglied (7) in Verbindung steht.

13. Regelanordnung nach einem der Ansprüche 10 bis 12 **dadurch gekennzeichnet, dass** eine vierte Regelstufe (25) zum Ermitteln einer vierten Stellgröße vorgesehen ist, der die am Ausgang des HF-Verstärkers (2) gemessene Leistung zugeführt ist und die mit dem Längsglied (7) in Verbindung steht.

14. Regelanordnung nach einem der Ansprüche 10 bis 13,
**dadurch gekennzeichnet, dass** eine fünfte Regelstufe (26) zum Ermitteln einer fünften Stellgröße aus dem am Ausgang des Längsglieds (7) gemessenen Strom und einem vorgegebenen maximalen Sollwert für den Strom vorgesehen ist, die mit dem Längsglied (7) in Verbindung steht.

15. Regelanordnung nach einem der Ansprüche 12 bis 14, **dadurch gekennzeichnet, dass** eine Auswahleinrichtung (24) zur Auswahl der an das Längsglied (7) zu übermittelnden Stellgröße vorgesehen ist.

16. Regelanordnung nach einem der Ansprüche 10 bis 15, **dadurch gekennzeichnet, dass** ein Befehlsgeber (32), insbesondere ein Pulsgenerator vorgesehen ist, der mit einem Oszillator (31) zur Ansteuerung des HF-Verstärkers (2) und dem Längsglied (7) oder einem mit dem Längsglied (7) verbundenen Schalterelement (42) verbunden ist.

17. Regelanordnung nach Anspruch 16, **dadurch gekennzeichnet, dass** der Befehlsgeber (32) mit mindestens einer Regelstufe (5, 23, 25, 26) verbunden ist.

## Claims

1. Method of controlling the input voltage of a high frequency amplifier (2) with the following steps:
a) measuring of the power supplied to a load (3) and/or reflected by a load (3);
b) determining a first control variable for a series element (7) disposed upstream from the high frequency amplifier (2) from the measured power and a given set point (6);
**characterized by**
c) determining a second control variable for a switched DC supply unit (9) from the voltage drop across the series element (7) such that the voltage drop across the series element (7) does not exceed a given maximum value and does not fall below a given minimum value, wherein the series element (7) is switched on and off for operating the high frequency amplifier (2) in pulsed operation.

2. Method according to claim 1, **characterized in that** the control rate for controlling the series element (7) is shorter than the control rate for controlling the DC supply unit (9).

3. Method according to claim 1 or 2, **characterized in that** a third control variable for the series element (7) is determined from the voltage U_{DS} present at a switching element of the high frequency amplifier (2) and a set point for the maximum voltage U_{DS}.

4. Method according to any one of the preceding claims, **characterized in that** a fourth control variable for the series element (7) is determined from the power measured at the output of the high frequency amplifier (2) and a given power set point.

5. Method according to any one of the preceding claims, **characterized in that** a fifth control variable is determined from a current measured at the output of the series element (7) and a given internal set point for the maximum current.

6. Method according to any one of the claims 3 through 5, **characterized in that** only the largest control variable is transferred to the series element (7).

7. Method according to any one of the preceding claims, **characterized in that** the control rate for the first, third, fourth or fifth control variable is << 10ms.

8. Method according to any one of the preceding claims, **characterized in that** the series element (7) and an oscillator (31) connected to the high frequency amplifier (2) are switched on and off synchronously.

9. Method according to claim 8, **characterized in that** at least one control stage (5, 23, 25, 26) is also switched on and off synchronously with the series element (7).

10. Control arrangement (1, 20, 30) of a high frequency amplifier (2) for performing the method according to any one of the preceding claims with a series element (7) which is disposed upstream from the high frequency amplifier (2) and is allocated to a first control stage (5) for determining a first control variable from the power supplied to a load (3) and/or reflected by the load (3) and a set point (6), **characterized in that** there is provided a switched DC supply unit (9) with an allocated second control stage (8), which determines a second control variable from the voltage drop across the series element (7), in such a way that the voltage drop across the series element does not exceed a given maximum value and does not fall below a given minimum value, wherein the series element is designed as a series element (7), which can be switched on and off for operating the high frequency amplifier in a pulsed operation.

11. Control arrangement according to claim 10, **characterized in that** the series element (7) comprises at least one semiconductor element, in particular a transistor.

12. Control arrangement according to claim 10 or 11, **characterized in that** a third control stage (23) connected to the series element (7) is provided for determining a third control variable, which third control stage (23) is supplied with the voltage U_{DS} present at a switching element of the RF amplifier.

13. Control element according to any one of the claims 10 through 12, **characterized in that** a fourth control stage (25) connected to the series element (7) is provided for determining a fourth control variable, which fourth control stage (25) is supplied with the power measured at the output of the RF amplifier (2).

14. Control element according to any one of the claims 10 through 13, **characterized in that** a fifth control stage (26) connected to the series element (7) is provided for determining a fifth control variable from the current measured at the output of the series element (7) and a given maximum set point for the current.

15. Control arrangement according to any one of the claims 12 through 14, **characterized in that** a selection means (24) is provided for selecting the control variable to be transferred to the series element (7).

16. Control arrangement according to any one of the claims 10 through 15, **characterized in that** a command unit (32), in particular a pulse generator, is provided, which is connected to an oscillator (31) for driving the HF amplifier (2) and to the series element (7) or to a switching element (42) connected to the series element (7).

17. Control arrangement according to claim 16, **characterized in that** the command unit (32) is connected to at least one control stage (5, 23, 25, 26).

## Revendications

1. Procédé de régulation de la tension d'entrée d'un amplificateur haute fréquence (2), comprenant les étapes de procédé suivantes :
a) mesure de la puissance fournie à une charge (3) et/ou réfléchie par la charge (3) ;
b) détermination d'une première grandeur réglante pour un élément série (7) placé en amont de l'amplificateur haute fréquence (2) à partir de la puissance mesurée et d'une valeur de consigne prédéfinie (6) ;
**caractérisé par**
c) détermination d'une deuxième grandeur réglante pour une unité d'alimentation en courant continu commutée (9) à partir de la chute de tension sur l'élément série (7), de telle façon que la chute de tension sur l'élément série (7) ne soit pas supérieure à une valeur maximale prédéfinie et pas inférieure à une valeur minimale prédéfinie, l'élément série (7) étant activé et désactivé pour faire fonctionner l'amplificateur haute fréquence (2) en mode pulsé.

2. Procédé selon la revendication 1, **caractérisé en ce que** l'élément série (7) est régulé plus rapidement que l'unité d'alimentation en courant continu (9).

3. Procédé selon la revendication 1 ou 2, **caractérisé en ce qu'**une troisième grandeur réglante pour l'élément série (7) est déterminée à partir de la tension U_{DS} présente à un élément commutateur de l'amplificateur haute fréquence (2) et d'une valeur de consigne pour la tension U_{DS} maximale.

4. Procédé selon une des revendications précédentes, **caractérisé en ce qu'**une quatrième grandeur réglante pour l'élément série (7) est déterminée à partir de la puissance mesurée à la sortie de l'amplificateur haute fréquence (2) et d'une valeur de consigne prédéfinie pour la puissance.

5. Procédé selon une des revendications précédentes, **caractérisé en ce qu'**une cinquième grandeur réglante est déterminée à partir d'un courant mesuré à la sortie de l'élément série (7) et d'une valeur interne prédéfinie pour le courant maximal.

6. Procédé selon une des revendications 3 à 5, **caractérisé en ce que** seule la grandeur réglante la plus grande est amenée à l'élément série (7).

7. Procédé selon une des revendications précédentes, **caractérisé en ce que** la durée de régulation pour la première, troisième, quatrième et cinquième grandeur réglante est << 10 ms.

8. Procédé selon une des revendications précédentes, **caractérisé en ce que** l'élément série (7) et un oscillateur (31) relié à l'amplificateur haute fréquence (2) sont activés et désactivés de façon synchrone.

9. Procédé selon la revendication 8, **caractérisé en ce qu'**au moins un étage de régulation (5, 23, 25, 26) est également activé et désactivé de façon synchrone avec l'élément série (7).

10. Dispositif de régulation (1, 20, 30) d'un amplificateur haute fréquence (2) pour réaliser le procédé selon une des revendications précédentes, avec un élément série (7) placé en amont de l'amplificateur haute fréquence (2), auquel est associé un premier étage de régulation (5) pour déterminer une première grandeur réglante à partir de la puissance fournie à une charge (3) et/ou de la puissance réfléchie par la charge (3) et d'une valeur de consigne (6), **caractérisé en ce qu'**il est prévu une unité d'alimentation en courant continu commutée (9) avec un deuxième étage de régulation (8) associé à celle-ci déterminant une deuxième grandeur réglante à partir de la chute de tension sur l'élément série (7) de telle façon que la chute de tension sur l'élément série ne soit pas supérieure à une valeur maximale prédéfinie et pas inférieure à une valeur minimale prédéfinie, l'élément série étant réalisé sous la forme d'un élément série (7) activable et désactivable pour faire fonctionner l'amplificateur haute fréquence en mode pulsé.

11. Dispositif de régulation selon la revendication 10, **caractérisé en ce que** l'élément série (7) présente au moins un élément à semi-conducteurs, en particulier un transistor.

12. Dispositif de régulation selon la revendication 10 ou 11, **caractérisé en ce qu'**il est prévu un troisième étage de régulation (23) pour déterminer une troisième grandeur réglante, auquel est amenée la tension U_{DS} présente à un élément commutateur de l'amplificateur HF et qui est relié à l'élément série (7).

13. Dispositif de régulation selon une des revendications 10 à 12 **caractérisé en ce qu'**il est prévu un quatrième étage de régulation (25) pour déterminer une quatrième grandeur réglante, auquel est amenée la puissance mesurée à la sortie de l'amplificateur HF (2) et qui est relié à l'élément série (7).

14. Dispositif de régulation selon une des revendications 10 à 13, **caractérisé en ce qu'**il est prévu un cinquième étage de régulation (26) pour déterminer une cinquième grandeur réglante à partir du courant mesuré à la sortie de l'élément série (7) et d'une valeur de consigne maximale prédéfinie pour le courant, qui est relié à l'élément série (7).

15. Dispositif de régulation selon une des revendications 12 à 14, **caractérisé en ce qu'**il est prévu un dispositif de sélection (24) pour sélectionner la grandeur réglante à transmettre à l'élément série (7).

16. Dispositif de régulation selon une des revendications 10 à 15, **caractérisé en ce qu'**il est prévu un émetteur d'ordres (32), en particulier un générateur d'impulsions, qui est relié à un oscillateur (31) servant à commander l'amplificateur HF (2) et à l'élément série (7) ou à un élément commutateur (42) relié à l'élément série (7).

17. Dispositif de régulation selon la revendication 16, **caractérisé en ce que** l'émetteur d'ordres (32) est relié à au moins un étage de régulation (5, 23, 25, 26).
